# EUROPÄISCHE PATENTSCHRIFT

(11) **EP 3 789 774 B1**
(45) Veröffentlichungstag und Bekanntmachung des Hinweises auf die Patenterteilung: **19.08.2026**
(21) Anmeldenummer: 19202743.1
(22) Anmeldetag: 11.10.2019
(51) Int. Cl.: G01R 11/04, G01D 11/24, G01R 22/06

(54) **ZÄHLERGEHÄUSE**
METER HOUSING
BOITIER DE COMPTEUR

(30) Priorität: 05.09.2019 CH 11212019
(43) Veröffentlichungstag der Anmeldung: 10.03.2021
(73) Patentinhaber: Semax AG, 6330 Cham (CH)
(72) Erfinder: FISCHER, Severin, 6300 Zug (CH)
(74) Vertreter: Schirbach, Marcel

(56) Entgegenhaltungen:
- EP-A1- 1 731 914
- WO-A1-2006/021119
- WO-A1-2007/056878
- WO-A1-2014/051619
- DE-A1- 10 022 532

## Beschreibung

### Technisches Gebiet

Die vorliegende Erfindung fällt in das technische Gebiet der Gehäuse für Geräte zur Verbrauchserfassung von Versorgungsgütern; sie betrifft vorliegend ein Zählergehäuse gemäss Anspruch 1.

### Stand der Technik

Gehäuse für Geräte zur Verbrauchserfassung von Versorgungsgütern, wie beispielsweise Elektrizität, Wasser, Wärme, Kälte, oder Gas sind hinlänglich als Zählergehäuse aus dem Stand der Technik bekannt; derartige Zählergehäuse sind offenbart in den Druckschriften EP 1 789 809 B1, EP 1 731 914 B1 und WO 2007/056878 A1. Diesen Zählergehäusen ist gemeinsam, dass sie im betriebsbereiten Zustand folgendes umfassen, namentlich eine Anzahl Anschlüsse eines Versorgungsguts, welche Anschlüsse von aussen zu einer Anzahl Messeinheiten in einem Innenraum des Zählergehäuses führen, wobei der Innenraum dieses Zählergehäuses zum einen mittels Befestigungsmitteln vollständig verschlossen ist und darüber hinaus -die zumeist geeichten- Messeinheiten in diesem Innenraum mittels einer äusseren Plombierung des Zählergehäuses zur Betrugserkennung versiegelt sind. Insbesondere wird in der EP 1 731 914 B1 offenbart, dass bei einem elektrischen und/oder elektronischen Gerät eine Funktionseinheit in einem Betriebszustand des Gerätes unlösbar an diesem angeordnet ist. Die Funktionseinheit ist aus einer Betriebsposition in eine Serviceposition und zurück bedienbar zwecks Handhabung einer an der Funktionseinheit angeordneten Anzahl von Baueinheiten, welche Anzahl Baueinheiten in der Betriebsposition der Funktionseinheit im Gerät eine Wirkverbindung aufweisen und wobei die Baueinheiten in der Serviceposition der Funktionseinheit frei sind von einer Wirkverbindung. In Speziellen offenbart die WO 2007/056878 A1, dass bei einer Zählerplattform für die Installation eines Elektrizitätszählers ein ein- oder mehrphasiger, fernbedienbarer Trennschalter vorgesehen ist, der zwischen einem oder mehreren Anschlüssen eines Stromversorgungsnetzes und einer dem Elektrizitätszähler nachgeschalteten Last angeordnet ist. In der DE 100 22 532 A1 ist eine Stromzählervorrichtung offenbart, die einen elektronischen Stromzähler enthält, der ein Zählergehäuse mit einem plombierbaren Zählerdeckel aufweist, und einen integrierten Rundsteuerempfänger. Die WO 2014/051619 A1 offenbart eine intelligente elektronische Vorrichtung zur Messung einer Eigenschaft von Elektrizität, die eine hintere Öffnung und eine seitliche Öffnung in einem Gehäuse der Vorrichtung zur Aufnahme eines Verbinders eines Erweiterungsmoduls durch die eine oder die andere Öffnung aufweist. Die WO 2006/021119 A1 offenbart eine intelligente elektronische Vorrichtung zur Messung einer Eigenschaft von Elektrizität, die eine hintere Öffnung und eine seitliche Öffnung in einem Gehäuse der Vorrichtung zur Aufnahme eines Verbinders eines Erweiterungsmoduls durch die eine oder die andere Öffnung aufweist.

Heutzutage ist es üblich, dass Zählergehäuse der eingangs vorgestellten Art, Möglichkeit zur Erweiterung mittels eines Zusatzmoduls oder mehrerer Zusatzmodule bietet, welche Zusatzmodule in Abhängigkeit von Randbedingungen am Installationsort, eine Kommunikation, beispielsweise über Mobilfunk (2G, 3G, 4G, 5G,...), Ethernet, Glasfaser, Mesh-Netzwerk, M-Bus oder RS-485 bereitstellen, oder eine Relaissteuerung als Schaltmodul. Auf Wunsch eines Versorgungsunternehmens oder eines Endverbrauchers des Versorgungsguts können Zählergehäuse bereits bei der Erstinstallation mit einem oder mehreren Zusatzmodulen ausgerüstet sein oder aber zu einem späteren Zeitpunkt nachgerüstet werden. Unabhängig von der Funktion eines Zusatzmoduls, verbleiben geeichte Messeinheiten im Zählergehäuse bei Normalbetrieb von einem Zusatzmodul vollkommen unberührt bzw. unbeeinflusst, wobei diese Zusatzmodule dennoch zwecks Signalerfassung, eigener Energieversorgung oder Kommunikation zum Innenraum des Zählergehäuses hin oder ausgangsseitig wahlweise leitungsgebunden bzw. steckkontaktgebunden und/oder drahtlos betrieben werden können.

In der bereits zitierten EP 1 789 809 B1 ist gezeigt, wie ein Zusatzmodul konventionell in einer Ausnehmung eines Zählergehäuses angeordnet ist und dabei über Steckkontakte bzw. Federkontakte in eine Wirkverbindung nach innen gebracht wird, wobei ausgangsseitig eine Anzahl Klemmenanschlüsse für eine leitungsgebundene Weiterleitung bereitstehen. Anhand dieses Beispiels ist bereits erschöpfend ersichtlich, dass die Anzahl verwendbarer Zusatzmodule an bekannten Zählergehäusen bei deren Ausgestaltung zu berücksichtigen ist und zudem eine notwendige Leitungsverlegung zu bzw. von einem Zusatzmodul bzw. von bzw. zu einem Zählgehäuse an dessen Zählermontageplatz zu berücksichtigen und vorgängig einzuplanen ist, um nicht nur bei der Erstinstallation, sondern auch bei Bedarf zu einem späteren Zeitpunkt, eine Ergänzung bzw. Nachrüstung zu ermöglichen. Allerdings kann an räumlich knapp bemessenen Installationsorten und gegebenenfalls unmittelbar benachbarten Zählergehäusen, die mit oder ohne Zusatzmodulen ausgestattet sein können, eine Leitungsverlegung zwischen Zählergehäusen untereinander, zwischen Zählergehäusen und Zusatzmodulen, oder zwischen Zusatzmodulen untereinander eine Herausforderung darstellen.

### Darstellung der Erfindung

Es ist deshalb Aufgabe der vorliegenden Erfindung, ein Zählergehäuse für ein Gerät zur Verbrauchserfassung eines Versorgungsguts dahingehend weiterzubilden, dass gegenüber dem Stand der Technik eine vereinfachte mechanische sowie elektrische Installation an einem Zählermontageplatz ermöglicht wird, auch dann, wenn gegebenenfalls mehrere Zählergehäuse benachbart zueinander an dem Zählermontageplatz angeordnet sind und zudem gegebenenfalls ein Zusatzmodul oder mehrere Zusatzmodule für das eine Gerät oder mehrere Geräte zur Verbrauchserfassung zum Einsatz gelangen und Leitungen drahtgebundene Verbindungen zwischen benachbarten Zählergehäusen, oder zwischen Zählergehäusen und Zusatzmodulen, oder zwischen Zusatzmodulen untereinander bereitstellen.

Die der Erfindung für das Zählergehäuse zugrunde liegende Aufgabe wird gelöst durch die Merkmale des Anspruchs 1; die diesen Erfindungsgedanken weiterbildenden Merkmale sind Gegenstand der Unteransprüche 2 bis 5.

Der Kern der vorliegenden Erfindung für Zählergehäuse für ein Gerät zur Verbrauchserfassung eines Versorgungsguts ist darin zu sehen, dass dieses Zählergehäuse ein vorderes Gehäuseteil und ein hinteres Gehäuseteil aufweist und zum einen hiermit einen Innenraum mit einer Verbrauchsguterfassungseinrichtung und einer zugehörigen Auswerteeinheit unzugänglich umfasst, und zum anderen das hintere Gehäuseteil auf seiner dem vorderen Gehäuseteil abgewandten Seite einem Zählermontageplatz zugewandt ist, wobei an diesem hinteren Gehäuseteil an einer ersten Gehäusewand eine in den Innenraum hineinragende Anschlusseinheit für das Verbrauchsgut angeordnet ist, und wobei das hintere Gehäuseteil eine der ersten Gehäusewand gegenüberliegende, zweite Gehäusewand aufweist und die erste Gehäusewand mit der zweiten Gehäusewand über eine dritte Gehäusewand und eine vierte Gehäusewand miteinander verbunden sind, und das hintere Gehäuseteil auf seiner dem Zählermontageplatz zugewandten Seite eine erste, zu diesem Zählermontageplatz offene Ausnehmung aufweist, die derart ausgebildet ist, dass darin eine Leitung anordenbar ist oder mehrere Leitungen anordenbar sind, welche Leitung bzw. welche Leitungen mit dem Zählergehäuse am Zählermontageplatz nach aussen hin abdeckbar ist bzw. abdeckbar sind. Dabei ist von Vorteil, dass in der zum Zählermontageplatz offenen Ausnehmung Leitungen versorgbar sind, die vom Zählermontageplatz zum Zählergehäuse oder vom Zählergehäuse zum Zählermontageplatz in Einsatz gelangen und durch dieses Zählergehäuse im montierten Zustand unzugänglich verdeckt sind. Somit ermöglicht das erfindungsgemässe Zählergehäuse mit der Ausnehmung eine vorteilhafte, platzsparende Montage des Zählergehäuses selbst begleitet von der geschützten Montage zugeführter oder abgeführter Leitungen. Eine solche Leitung dient beispielsweise einer drahtgebundenen Kommunikation. So eine drahtgebundene Kommunikation unterliegt nicht denjenigen, strengen Vorschriften wie der Inhalt des verschlossenen Innenraums, der eine zugangsgeschützte, meist einer Eichung unterliegenden Verbrauchsguterfassungseinrichtung mit zugehöriger Auswerteeinheit umfasst.

Bei dem erfindungsgemässen Zählergehäuse ist das hintere Gehäuseteil und das vordere Gehäuseteil mittels eines Anschlussdeckels abschliessend verbindbar, womit die Anschlusseinheit, die gegenüber dem Zählermontageplatz offen verbleibt, nach aussen hin verschliessbar ist, wobei die erste Gehäusewand des hinteren Gehäuseteils neben der Anschlusseinheit eine erste Öffnung oder eine erste Gehäuseausbrechung für diese erste Öffnung aufweist, wobei im offenen Zustand dieser ersten Öffnung, die erste Ausnehmung mit einer zweiten Ausnehmung unter dem Anschlussdeckel verbindbar ist. Somit ist es möglich, dass Leitungen, die in der ersten Ausnehmung angeordnet sind, auch in die zweite Ausnehmung unter den Anschlussdeckel und dadurch konsequenterweise in die Nähe der Anschlusseinheit führbar sind, wo gegebenenfalls auch eine Schnittstelle für eine drahtgebundene Kommunikation angeordnet sein kann.

Eine weitere Ausführungsform des erfindungsgemässen Zählergehäuses weist eine zweite Öffnung oder eine zweite Gehäuseausbrechung für diese zweite Öffnung zu der ersten Ausnehmung hin auf, und zwar an der der ersten Gehäusewand des hinteren Gehäuseteils gegenüberliegenden, zweiten Gehäusewand, wobei diese zweite Öffnung mittels eines ersten Zusatzmoduls für das Gerät zur Verbrauchserfassung des Versorgungsguts verschliessbar ist; somit sind auch Leitungen drahtgebundener Zusatzmodule in die erste bzw. durch die erste in die zweite Ausnehmung führbar, was z.B. auch eine Energieversorgung eines solchen Zusatzmoduls aus der zweiten Ausnehmung heraus ermöglicht.

Bei einer weiteren vorteilhaften Ausführungsform des erfindungsgemässen Zählergehäuses ist vorgesehen, dass die dritte Gehäusewand des hinteren Gehäuseteils als eine erste Seitenwand ausgebildet ist und/oder die vierte Gehäusewand des hinteren Gehäuseteils als eine zweite Seitenwand ausgebildet ist, wobei diese erste bzw. zweite Seitenwand eine erste bzw. zweite Seitenwandöffnung oder eine vierte bzw. eine fünfte Gehäuseausbrechung für diese erste bzw. zweite Seitenwandöffnung aufweisen. Diese Seitenwandöffnungen erlauben eine drahtgebundene Verbindung zwischen benachbarten Zählergehäusen und/oder eine drahtgebundene Verbindung auch zwischen Zusatzmodulen benachbarter Zählergehäusen.

### Kurze Beschreibung der Zeichnungen

Im Folgenden wird die Erfindung anhand von Figuren beispielhaft erläutert. Gleiche Gegenstände sind in den Figuren grundsätzlich mit gleichen Bezugszeichen bezeichnet. Es zeigen rein schematisch die
- Fig. 1: eine perspektivische Darstellung einer Frontseite eines erfindungsgemässen Zählergehäuses von unten;
- Fig. 2: eine rückseitige, perspektivische Darstellung von einer Seite des Zählergehäuses gemäss Fig. 1 mit einer ersten Ausnehmung in einem hinteren Gehäuseteil, welches einem -nicht dargestellten-Zählermontageplatz zugewandt ist und einer zweiten Ausnehmung unter einem Anschlussdeckel;
- Fig. 3: eine weitere rückseitige, perspektivische Darstellung von oben auf das Zählergehäuse gemäss Fig.1;
- Fig. 4: eine weitere perspektivische Darstellung der Frontseite gemäss Fig. 1;
- Fig. 5: zeigt Gehäuseausbrechungen des Zählergehäuses gemäss Fig. 1;
- Fig. 6: Leitungen in der ersten und der zweiten Ausnehmung;
- Fig. 7: eine perspektivische Frontansicht des erfindungsgemässen Zählergehäuses von oben auf ein Zusatzmodul;
- Fig. 8: eine perspektivische, seitliche Explosionsdarstellung des erfindungsgemässen Zählergehäuses;
- Fig. 9: eine weitere perspektivische Darstellung der Frontseite von unten des erfindungsgemässen Zählergehäuses.

### Wege zur Ausführung der Erfindung

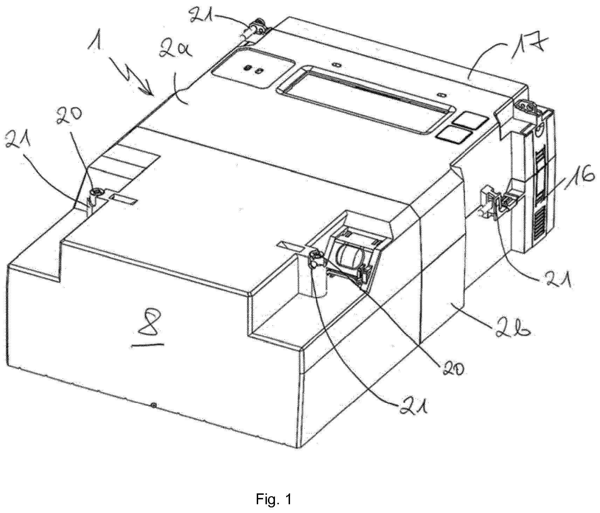

Fig. 1 zeigt das erfindungsgemässe Zählergehäuse 1, welches vorliegend als ein Elektrizitätszählergehäuse 1 für einen Elektrizitätszähler zur Messung verbrauchter oder gegebenenfalls zurückgespeister, elektrischer Energie ausgebildet ist; dieses Zählergehäuse 1 ist auch für Zählergehäuse 1 geeignet, die beispielsweise bei Verbrauchszählern zwecks Erfassung anderer Versorgungsgüter wie Wasser, Wärme, Kälte oder Gas zum Einsatz gelangen können. In einer hier vorliegenden, perspektivischen Frontansicht von schräg unten umfasst das Zählergehäuse 1 ein vorderes Gehäuseteil 2a und ein hinteres Gehäuseteil 2b, welche beide im betriebsbereiten Montagezustand des Zählergehäuses 1 in dessen oberen Bereich mittels eines Gehäusedeckels 17 und unten mittels eines Anschlussdeckels 8 bzw. eines Klemmendeckels 8 verbindend verschlossen sind. Ein Verschlussschieber 16 fixiert den Gehäusedeckel 17 an dem vorderen und hinteren Gehäuseteil 2a, 2b.

Bekanntermassen sind Zählergehäuse 1 für die Verbrauchserfassung von Versorgungsgütern mit einer Anzahl Befestigungsmitteln 20 verschlossen und ferner mit einer Anzahl Plombierungen 21 versiegelt. Im gezeigten Beispiel ist ein Befestigungsmittel 20 als eine Schraube 20 mit einem Kreuzschlitz ausgebildet und die Plombierung 21 umfasst beispielhaft -oben links am Zählergehäuse- einen Plombierstift.

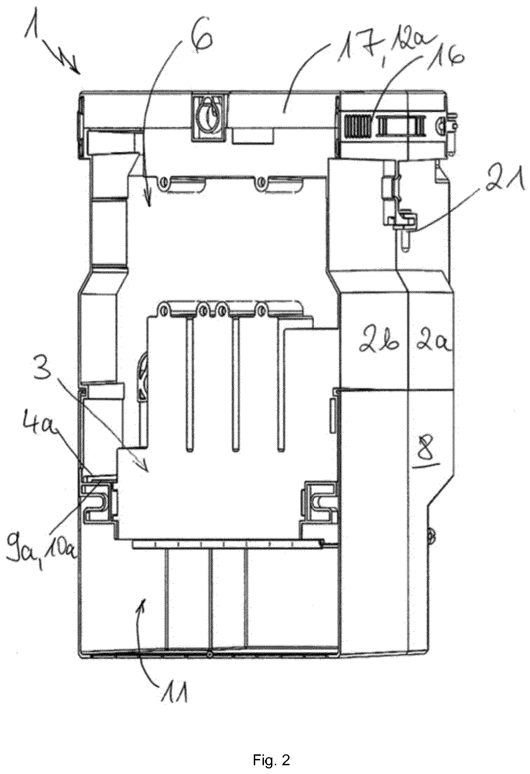

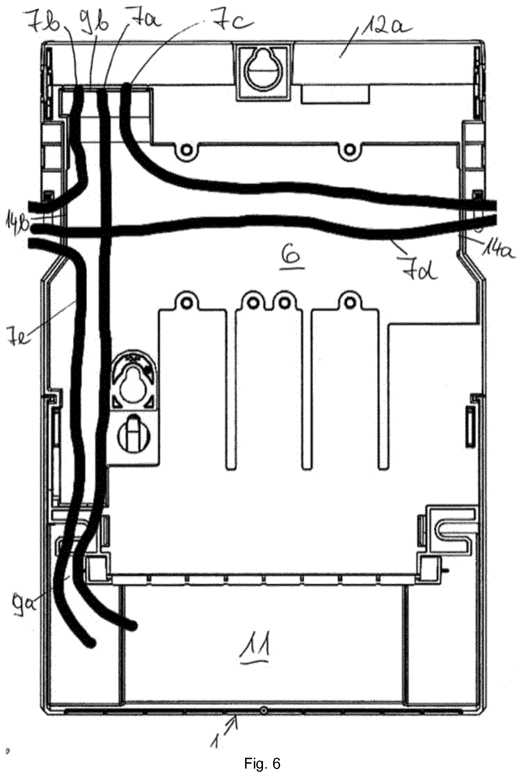

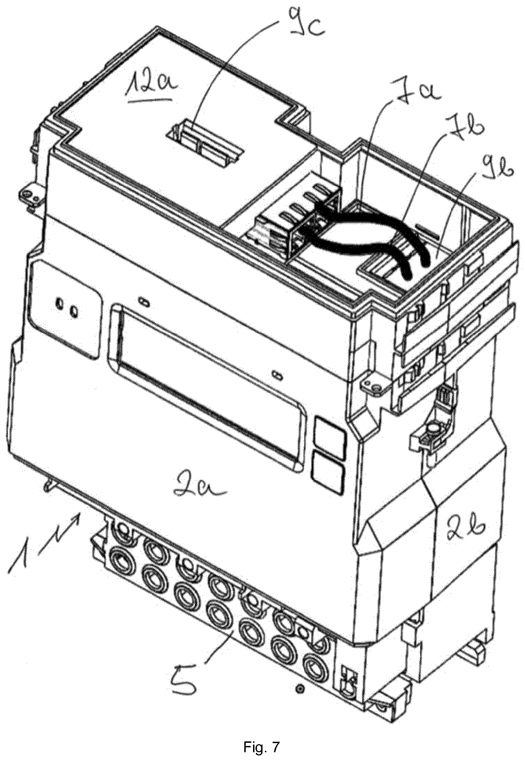

Wie in einer perspektivischen, seitlichen Rückansicht in Fig. 2 dargestellt, weist das erfindungsgemässe Zählergehäuse 1 eine erste Ausnehmung 6 im hinteren Gehäuseteil 2b auf. Diese erste Ausnehmung 6 ist zum einen umschlossen von Gehäusewänden des Zählergehäuses 1 bzw. des hinteren Gehäuseteils 2b und zum anderen ist diese Ausnehmung 6 im betriebsbereiten Zustand des Zählergehäuses 1 an einem -hier nicht gezeigten- Zählermontageplatz gegenüber diesem Zählermontageplatz verschlossen. Wie nachfolgend zu zeigen sein wird, ist diese erste Ausnehmung 6 dazu vorgesehen, Leitungen -welche nachfolgend anhand der Fig. 6 und 7 gezeigt werdendarin aufzunehmen, welche Leitungen bei der Montage des Zählergehäuses 1 am Zählermontageplatz zu versorgen sind.

Ein Innenraum 3 des Zählergehäuses 1 ist «vorliegend quasi von aussen» gezeigt, welcher Innenraum 3 durch das vordere Gehäuseteil 2a und das hintere Gehäuseteil 2b vollständig verschliessbar ist, wobei in diesem Innenraum 3 regulär eine -hier nicht näher gezeigte- Verbrauchsguterfassungseinrichtung mit einer zugehörigen Auswerteeinheit unzugänglich untergebracht ist. Das vordere und hintere Gehäuseteil 2a, 2b sind mittels des Anschlussdeckels 8 nach unten verschlossen, womit unterhalb des Innenraums 3 eine zweite Ausnehmung 11 ebenfalls zum hier nicht dargestellten Zählermontageplatz verschlossen ist; ferner sind die Gehäuseteile 2a, 2b -wie bereits zu Fig. 1 erläutert- nach oben mittels eines Gehäusedeckels 17 verschlossen, wobei dieser Gehäusedeckel 17 auch als ein erstes Zusatzmodul 12a ausgebildet sein kann.

Das hintere Gehäuseteil 2b weist eine erste Gehäusewand 4a auf, welche als eine erste Gehäuseausbrechung 10a bzw. als eine erste Gehäuseausbruchstelle 10a ausgebildet ist; es sei angemerkt, dass die Ausdrücke «Gehäuseausbrechung» und «Gehäuseausbruchstelle» gleichbedeutend sind und synonym verwendet werden. Solche erste Gehäuseausbrechungen 10a sind optional ausbrechbar, womit sich eine erste Öffnung 9a zwischen der ersten Ausnehmung 6 und der zweiten Ausnehmung 11 ergibt und somit beide miteinander verbindet.

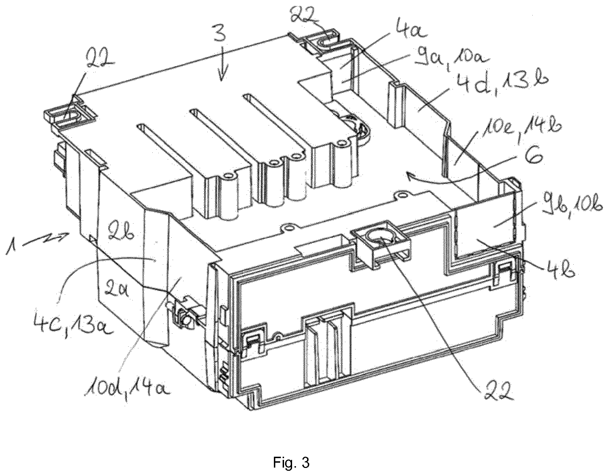

Fig. 3 zeigt eine weitere perspektivische Rückansicht des erfindungsgemässen Zählergehäuses 1 mit Blick auf die bereits oben erwähnte, erste Gehäusewand 4a, welche als erste Gehäuseausbrechung 10a ausgebildet ist und nach Entfernung die erste Öffnung 9a der ersten Ausnehmung 6 darstellt. Diese erste Ausnehmung 6 ist neben der ersten Gehäusewand 4a ferner begrenzt durch eine zweite, gegenüberliegende Gehäusewand 4b und eine dritte und vierte Gehäusewand 4c bzw. 4d, welche die erste und zweite Gehäusewände 4a und 4b miteinander verbinden. Die zweite Gehäusewand 4b ist in dieser Fig. 3 deswegen sichtbar, weil -hier nicht wie in Fig. 2- der Gehäusedeckel 17 bzw. das erste Zusatzmodul 12a das Zählergehäuse 1 oben verschliesst. Das hintere Gehäuseteil 2b weist neben der zweiten Gehäusewand 4b eine erste Befestigungsöse 22 auf und beidseits des Innenraums 3 eine zweite und dritte Befestigungsöse 22, mit welchen Befestigungsösen 22 das Zählergehäuse 1 an einem -hier nicht dargestellten- Zählermontageplatz befestigt werden kann, womit die erste Ausnehmung 6 im am Zählermontageplatz angeordneten Zählergehäuse 1 rückwärtig verschliessbar ist.

Die zweite Gehäusewand 4b ist als eine zweite Gehäuseausbrechung 10b ausgestaltet, welche nach Entfernung eine zweite Öffnung 9b zur ersten Ausnehmung 6 bereitstellt. Mit zusätzlichem Blick auf die Fig. 2 wird klar, dass diese zweite Öffnung 9b dem ersten Zusatzmodul 12a zugewandt ist, welches vorliegend in Fig. 3 nicht gezeigt ist.

Die dritte und vierte Gehäusewand 4c bzw. 4d stellen eine erste und zweite Seitenwand 13a bzw. 13b des hinteren Gehäuseteils 2b dar, welche Seitenwände 13a, 13b, vierte und fünfte Gehäuseausbrechungen 10d bzw. 10e aufweisen, welche bei Entfernung eine erste und eine zweite Seitenwandöffnung 14a, 14b ergeben; solche Seitenwandöffnungen 14a, 14b ermöglichen eine Verbindung zwischen ersten Ausnehmungen 6 benachbarter Zählergehäuse 1.

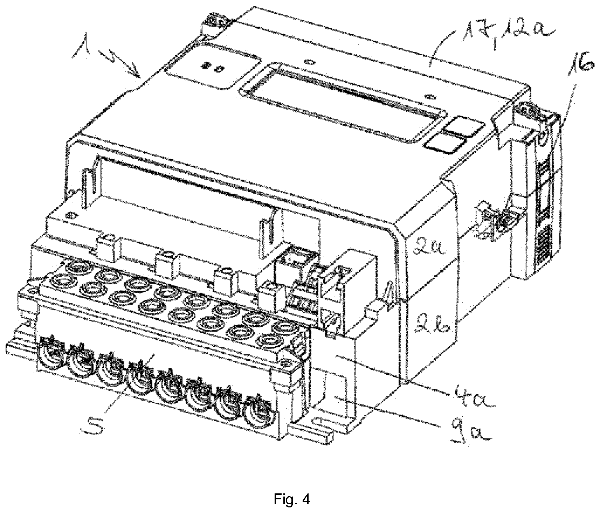

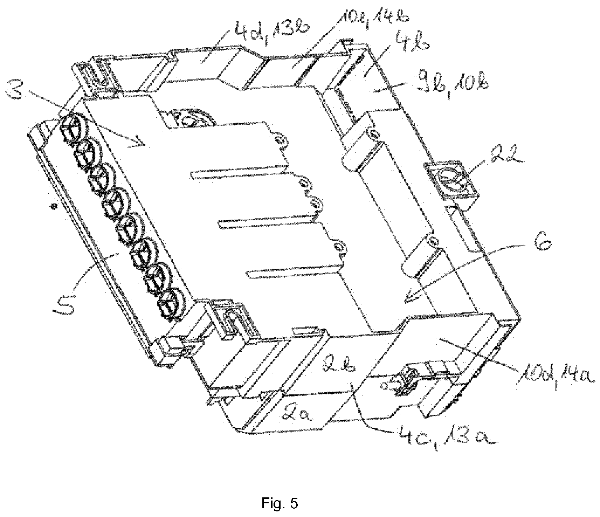

Fig. 4 zeigt eine ähnliche, perspektivische Frontansicht des erfindungsgemässen Zählergehäuses 1 wie die Fig. 1, allerdings ohne den dort dargestellten Anschlussdeckel/Klemmendeckel 8. Somit ist in dieser Fig. 4 eine Anschlusseinheit 5 sichtbar, die bei dem hier beispielhaft beschriebenen Zählergehäuse 1 für einen Elektrizitätszähler als Klemmenblock 5 ausgebildet ist. Neben diesem Klemmenblock ist die erste Öffnung 9a gezeigt, welche den Bereich um den Klemmenblock 5 mit der -in Fig. 3 gezeigten- ersten Ausnehmung 6 verbindet und wobei dieser Bereich um den Klemmenblock 5 die -in Fig. 2 gezeigte- zweite Ausnehmung 11 darstellt. Die Fig. 5 zeigt eine weitere Darstellung des erfindungsgemässen Zählergehäuses 1 gemäss Fig. 4 von dessen Rückseite, aus welcher Darstellung klar wird, dass der Klemmenblock 5 den mittels vorderem und hinterem Gehäuseteil 2a, 2b verschlossenen Innenraum 3 nach unten abschliesst.

In Fig. 6 ist das erfindungsgemässe Zählergehäuse 1 in einer rückwärtigen Draufsicht dargestellt, wobei eine Anzahl Leitungen 7a, 7b, 7c, 7d und 7e innerhalb der ersten Ausnehmung 6 angeordnet sind, wobei diese Leitungen 7a - 7e einadrig oder mehradrig ausgebildet sein können. Für die hier beispielhaft gezeigte Installation aller Leitungen 7a - 7e sind die erste und die zweite Öffnung 9a, 9b und die erste und zweite Seitenwandöffnung 14a, 14b notwendig; die Leitung 7a verbindet durch die erste und die zweite Öffnung 9a, 9b über die erste Ausnehmung 6 das erste Zusatzmodul 12a mit -hier nicht dargestellten- Anschlüssen in der zweiten Ausnehmung 11, was beispielsweise eine Stromversorgung oder eine Kommunikationsverbindung oder beides sein kann. Die Leitungen 7b, 7c führen vom ersten Zusatzmodul 12a durch die zweite Öffnung 9b in die erste Ausnehmung 6 und dann seitlich durch die zweite Seitenwandöffnung 14b bzw. die erste Seitenwandöffnung 14a aus dem Zählergehäuse 1 heraus, beispielsweise zu -hier nicht dargestellten- benachbarten, weiteren Zählergehäusen. Die Leitung 7d ist vorliegend beispielhaft als Durchgangsleitung von der zweiten Seitenwandöffnung 14b über die erste Ausnehmung 6 im erfindungsgemässen Zählergehäuse 1 zur ersten Seitenwandöffnung 14a ausgebildet und die Leitung 7e verbindet über die erste Öffnung 9a die zweite Ausnehmung 11 mit der ersten Ausnehmung 6 und ist dann aus der zweiten Seitenwandöffnung 14b aus diesem Zählergehäuse rausgeführt.

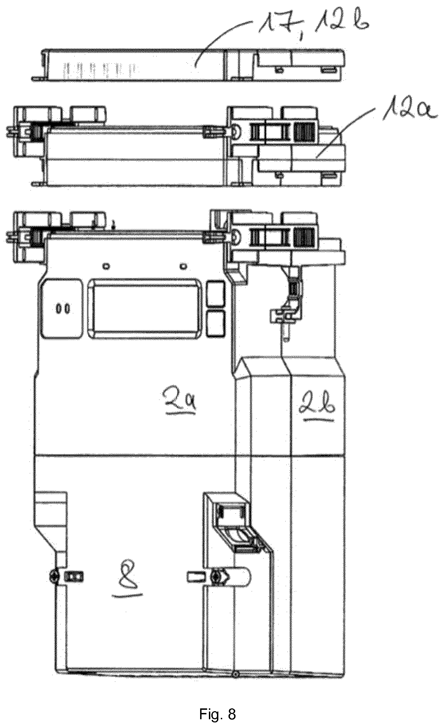

Fig. 7 zeigt in einer weiteren perspektivischen Ansicht des Zählergehäuses 1 gemäss der Erfindung wie die Leitungen 7a und 7b durch die zweite Öffnung 9b in das erste Zusatzmodul 12a hineinragen und dort angeschlossen sind. Ferner offenbart diese Ansicht eine dritte Öffnung 9c im ersten Zusatzmodul 12a, welche dritte Öffnung 9c vor dessen Entfernung mittels einer hier nicht gezeigten, dritten Gehäuseausbrechung verschlossen ist. In Fig. 8 ist in einer perspektivischen Explosionsdarstellung gezeigt, wie das erste Zusatzmodul 12a in Fig. 7 mittels des Gehäusedeckels 17 bzw. mittels eines weiteren Zusatzmoduls 12 b verschliessbar ist, wobei die dritte Öffnung 9c im ersten Zusatzmodul 12a für eine Verbindung mit dem zweiten Zusatzmodul 12b genutzt werden kann.

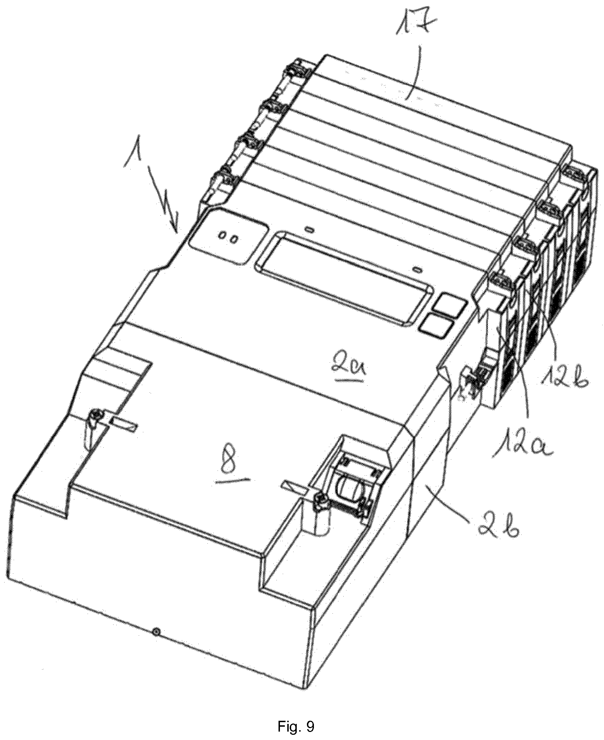

Die Fig. 9 offenbart, dass das erfindungsgemässe Zählergehäuse 1 mit der ersten Ausnehmung 6 -siehe auch Fig. 6 und 8- mittels mehrerer, aufeinander gesteckter Zusatzmodule 12a, 12b, ..., erweiterbar ist, wobei diese Zusatzmodule mittels Leitungen durch die erste Ausnehmung 6 so verbunden werden können, dass diese Leitungen im betriebsbereiten Zustand am Zählermontageplatz durch die Zählergehäuse vollständig abdeckbar sind.

## Patentansprüche

1. Zählergehäuse (1) für ein Gerät zur Verbrauchserfassung eines Versorgungsguts, wie beispielsweise Elektrizität, Wasser, Wärme, Kälte oder Gas, umfassend ein vorderes Gehäuseteil (2a), welches einen Innenraum (3) des Zählergehäuses (1) mit einem hinteren, zur Befestigung an einem Zählermontageplatz vorgesehenen Gehäuseteil (2b) vollständig umschliesst, wobei dieser Innenraum (3) eine Verbrauchsguterfassungseinrichtung mit einer zugehörigen Auswerteeinheit unzugänglich beinhaltet, welches hintere Gehäuseteil (2b) auf seiner dem vorderen Gehäuseteil (2a) abgewandten Seite dem Zählermontageplatz zugewandt ist, wobei an diesem hinteren Gehäuseteil (2b) an einer ersten Gehäusewand (4a) eine in den Innenraum (3) hineinragende Anschlusseinheit (5) für das Verbrauchsgut angeordnet ist, und wobei das hintere Gehäuseteil (2b) eine der ersten Gehäusewand (4a) gegenüberliegende, zweite Gehäusewand (4b) aufweist, und die erste Gehäusewand (4a) mit der zweiten Gehäusewand (4b) über eine dritte Gehäusewand (4c) und eine vierte Gehäusewand (4d) miteinander verbunden sind, wobei das hintere Gehäuseteil (2b) auf seiner dem Zählermontageplatz zugewandten Seite eine erste, zu diesem Zählermontageplatz offene Ausnehmung (6) aufweist, welche erste Ausnehmung (6) derart ausgebildet ist, dass darin eine Leitung (7a, b, c, d, e) anordenbar ist oder mehrere Leitungen (7a, b, c, d, e) anordenbar sind, welche Leitung (7a, b, c, d, e) oder welche Leitungen (7a, b, c, d, e) mit dem Zählergehäuse (1) am Zählermontageplatz nach aussen hin unzugänglich abdeckbar ist bzw. sind, wobei das hintere Gehäuseteil (2b) und das vordere Gehäuseteil (2a) mittels eines Anschlussdeckels (8) des Zählergehäuses (1) abschliessend verbindbar sind und damit die Anschlusseinheit (5), die gegenüber dem Zählermontageplatz offen ist, nach aussen hin verschliessbar ist, wobei die erste Gehäusewand (4a) am hinteren Gehäuseteil (2b) neben der Anschlusseinheit (5) eine erste Öffnung (9a) oder eine erste ausbrechbare Gehäuseausbruchstelle (10a) für diese erste Öffnung (9a) aufweist, wobei im offenen Zustand dieser ersten Öffnung (9a), die erste Ausnehmung (6) mit einer zweiten Ausnehmung (11) unter dem Anschlussdeckel (8) verbindbar ist.

2. Zählergehäuse (1) nach Anspruch 1, **dadurch gekennzeichnet, dass** die der ersten Gehäusewand (4a) des hinteren Gehäuseteils (2b) gegenüberliegende, zweite Gehäusewand (4b) eine zweite Öffnung (9b), oder eine zweite ausbrechbare Gehäuseausbruchstelle (10b) für diese zweite Öffnung (9b) zur ersten Ausnehmung (6) hin aufweist, wobei diese zweite Öffnung (9b) mittels eines ersten Zusatzmoduls (12a) für das Gerät zur Verbrauchserfassung des Versorgungsguts verschliessbar ist.

3. Zählergehäuse (1) nach Anspruch 2, **dadurch gekennzeichnet, dass** das erste Zusatzmodul (12a) eine dritte Öffnung (9c), oder eine dritte ausbrechbare Gehäuseausbruchstelle (10c) für diese dritte Öffnung (9c) aufweist, wobei diese dritte Öffnung (9c) mittels eines weiteren Zusatzmoduls (12b) für das Gerät zur Verbrauchserfassung des Versorgungsguts verschliessbar ist.

4. Zählergehäuse (1) nach einem der Ansprüche 1 bis 3, **dadurch gekennzeichnet, dass** die dritte Gehäusewand (4c) des hinteren Gehäuseteils (2b) als eine erste Seitenwand (13a) ausgebildet ist, welche eine erste Seitenwandöffnung (14a), oder eine vierte ausbrechbare Gehäuseausbruchstelle (10d) für diese erste Seitenwandöffnung (14a) zur ersten Ausnehmung (6) des hinteren Gehäuseteils (2b) aufweist.

5. Zählergehäuse (1) nach einem der Ansprüche 1 bis 4, **dadurch gekennzeichnet, dass** die vierte Gehäusewand (4d) des hinteren Gehäuseteils (2b) als eine zweite Seitenwand (13b) ausgebildet ist, welche eine zweite Seitenwandöffnung (14b) oder eine fünfte ausbrechbare Gehäuseausbruchstelle (10e) für diese zweite Seitenwandöffnung (14b) zur ersten Ausnehmung (6) des hinteren Gehäuseteils (2b) aufweist.

## Claims

1. Meter housing (1) for a device for measuring the consumption of a utility, such as electricity, water, heat, cooling or gas, comprising a front housing part (2a) which completely encloses an interior space (3) of the meter housing (1) together with a rear housing part (2b) intended for attachment to a meter mounting location, wherein this interior space (3) contains a utility consumption measurement device with an associated evaluation unit in a manner that is inaccessible, the rear housing part (2b) facing the meter installation site on its side facing away from the front housing part (2a), wherein on this rear housing part (2b) a connection unit (5) for the consumable, projecting into the interior space (3), is arranged on a first housing wall (4a), and wherein the rear housing part (2b) has a second housing wall (4b) opposite the first housing wall (4a), and the first housing wall (4a) is connected to the second housing wall (4b) via a third housing wall (4c) and a fourth housing wall (4d), wherein the rear housing part (2b) has, on its side facing the meter mounting location, a first recess (6) open towards this meter mounting location, which first recess (6) is configured such that a cable (7a, b, c, d, e) or several cables (7a, b, c, d, e) can be arranged therein, which cable (7a, b, c, d, e) or which cables (7a, b, c, d, e) can be covered meter housing (1) in such a way that they are inaccessible from the outside at the meter mounting location in a manner that renders them inaccessible from the outside, wherein the rear housing part (2b) and the front housing part (2a) can be connected in a sealed manner by means of a connection cover (8) of the meter housing (1), thereby allowing the connection unit (5), which is open towards the meter installation site, can be sealed off from the outside, wherein the first housing wall (4a) on the rear housing section (2b) adjacent to the connection unit (5) comprises a first opening (9a) or a first break-out point (10a) for this first opening (9a), wherein, when this first opening (9a) is open, the first recess (6) can be connected to a second recess (11) beneath the connection cover (8).

2. A meter housing (1) according to claim 1, **characterised in that** the second housing wall (4b), which lies opposite the first housing wall (4a) of the rear housing part (2b), comprises a second opening (9b), or a second break-out point (10b) for this second opening (9b) towards the first recess (6), wherein this second opening (9b) can be closed by means of a first additional module (12a) for the device for recording the consumption of the utility.

3. Meter housing (1) according to claim 2, **characterised in that** the first additional module (12a) comprises a third opening (9c), or a third break-out point (10c) for this third opening (9c), wherein this third opening (9c) can be closed by means of a further additional module (12b) for the device for recording the consumption of the utility.

4. Meter housing (1) according to any one of claims 1 to 3, **characterised in that** the third housing wall (4c) of the rear housing part (2b) is formed as a first side wall (13a) which has a first side wall opening (14a), or a fourth break-out point (10d) for this first side wall opening (14a) to the first recess (6) of the rear housing part (2b).

5. Meter housing (1) according to any one of claims 1 to 4, **characterised in that** the fourth housing wall (4d) of the rear housing part (2b) is formed as a second side wall (13b), which has a second side wall opening (14b) or a fifth break-out point (10e) for this second side wall opening (14b) to the first recess (6) of the rear housing part (2b).

## Revendications

1. Boîtier de compteur (1) destiné à un appareil de mesure de la consommation d'un bien de consommation, tel que l'électricité, l'eau, la chaleur, le froid ou le gaz, comprenant une partie avant de boîtier (2a) qui entoure complètement un espace intérieur (3) du boîtier de compteur (1) avec une partie arrière de boîtier (2b) prévue pour la fixation à un emplacement de montage de compteur, cet espace intérieur (3) renfermant de manière inaccessible un dispositif de mesure de la consommation avec une unité d'évaluation associée, ladite partie arrière (2b) du boîtier étant tournée vers le lieu de montage du compteur sur son côté opposé à la partie avant (2a) du boîtier, une unité de raccordement (5) pour le bien fourni, s'étendant dans l'espace intérieur (3), étant disposée sur cette partie arrière (2b) est disposée, sur une première paroi de boîtier (4a), une unité de raccordement (5) pour le produit consommable, qui s'étend dans l'espace intérieur (3), et la partie arrière du boîtier (2b) comportant une deuxième paroi de boîtier (4b) opposée à la première paroi de boîtier (4a), et la première paroi de boîtier (4a) et la deuxième paroi de boîtier (4b) sont reliées entre elles par l'intermédiaire d'une troisième paroi de boîtier (4c) et d'une quatrième paroi de boîtier (4d), la partie arrière du boîtier (2b) comportant, sur son côté tourné vers l'emplacement de montage du compteur, un premier évidement (6) ouvert vers cet emplacement de montage du compteur, lequel premier évidement (6) est conçu de telle sorte qu'un conduit (7a, b, c, d, e) ou plusieurs conduites (7a, b, c, d, e) puissent y être disposées, laquelle conduite (7a, b, c, d, e) ou lesquelles conduites (7a, b, c, d, e) peuvent être recouvertes de manière inaccessible de l'extérieur par rapport au boîtier du compteur (1) sur le lieu de montage du compteur de manière à ce qu'ils soient inaccessibles de l'extérieur, la partie arrière du boîtier (2b) et la partie avant du boîtier (2a) pouvant être reliées de manière étanche au moyen d'un couvercle de raccordement (8) du boîtier de compteur (1), ce qui permet de fermer l'unité de raccordement (5), qui est ouverte vers l'emplacement de montage du compteur, pouvant être fermée vers l'extérieur, la première paroi de boîtier (4a) de la partie arrière du boîtier (2b) présentant, à côté de l'unité de raccordement (5) une première ouverture (9a) ou un premier point de rupture (10a) pouvant être brisé pour cette première ouverture (9a), le premier évidement (6) pouvant être relié, lorsque cette première ouverture (9a) est ouverte, à un deuxième évidement (11) situé sous le couvercle de raccordement (8).

2. Boîtier de compteur (1) selon la revendication 1, **caractérisé en ce que** la deuxième paroi (4b) du boîtier, située en face de la première paroi (4a) de la partie arrière (2b) du boîtier, comporte une deuxième ouverture (9b), ou un deuxième point de rupture (10b) pouvant être brisé pour cette deuxième ouverture (9b) en direction du premier évidement (6), cette deuxième ouverture (9b) pouvant être obturée au moyen d'un premier module supplémentaire (12a) destiné à l'appareil de mesure de la consommation du produit fourni.

3. Boîtier de compteur (1) selon la revendication 2, **caractérisé en ce que** le premier module supplémentaire (12a) comporte une troisième ouverture (9c), ou un troisième emplacement de découpe (10c) pour cette troisième ouverture (9c), cette troisième ouverture (9c) pouvant être obturée au moyen d'un autre module supplémentaire (12b) destiné à l'appareil de mesure de la consommation du produit fourni.

4. Boîtier de compteur (1) selon l'une des revendications 1 à 3, **caractérisé en ce que** la troisième paroi (4c) de la partie arrière (2b) du boîtier est conçue comme une première paroi latérale (13a) qui présente une première ouverture (14a) dans la paroi latérale, ou un quatrième point de rupture (10d) de la paroi du boîtier pour cette première ouverture latérale (14a) vers le premier évidement (6) de la partie arrière (2b) du boîtier.

5. Boîtier de compteur (1) selon l'une des revendications 1 à 4, **caractérisé en ce que** la quatrième paroi (4d) de la partie arrière (2b) du boîtier est réalisée sous la forme d'une deuxième paroi latérale (13b) qui présente une deuxième ouverture de paroi latérale (14b) ou un cinquième point de rupture du boîtier (10e) pour cette deuxième ouverture de paroi latérale (14b) vers le premier évidement (6) de la partie arrière (2b) du boîtier.
